# EUROPEAN PATENT SPECIFICATION

(11) **EP 4 133 556 B1**
(45) Date of publication and mention of the grant of the patent: **06.08.2025**
(21) Application number: 20952733.2
(22) Date of filing: 09.09.2020
(51) Int. Cl.: H05K 1/14, H01R 24/50, H01R 13/24, H01R 24/44, H01R 103/00, H01R 12/70, H01R 12/91, H01R 4/04, H01R 43/16, H05K 1/02

(54) **A RADIO FREQUENCY CONNECTOR AND A COMMUNICATION MODULE HAVING THE SAME**
HOCHFREQUENZVERBINDER UND KOMMUNIKATIONSMODUL DAMIT
CONNECTEUR RADIOFRÉQUENCE ET MODULE DE COMMUNICATION DOTÉ DE CELUI-CI

(43) Date of publication of application: 15.02.2023
(73) Proprietor: Telefonaktiebolaget LM Ericsson (publ.), 16483 Stockholm (SE)
(72) Inventor: LI, Shuaijun, Beijing 100102 (CN); AN, Jianjun, Beijing 100102 (CN); ZHU, Mindu, Beijing 100102 (CN)
(74) Representative: Ericsson
(86) International application number: PCT/CN2020/114254
(87) International publication number: WO 2022/051945

(56) References cited:
- WO-A1-2014/075454
- WO-A1-2020/088105
- WO-A1-2020/099374
- WO-A1-2020/099375
- CN-U- 206 628 678
- US-A1- 2018 294 609
- US-A1- 2018 301 834
- US-A1- 2020 091 665
- US-A1- 2020 203 901
- US-B2- 7 909 668

## Description

### Technical Field

The present disclosure generally relates to the technical filed of communication device, and more particularly, to a radio frequency (RF) connector and a communication module comprising the same.

### Background

This section introduces aspects that may facilitate better understanding of the present disclosure. Accordingly, the statements of this section are to be read in this light and are not to be understood as admissions about what is in the prior art or what is not in the prior art.

RF connectors are widely applied in radio base station products from telecommunication industry. Most of the existing RF connectors are in coaxial type and are widely used in scenarios of connecting a radio board to an antenna board, connecting a radio board to a filter unit, or connecting a filter unit to an antenna board. The existing RF connectors are commonly in the form of 3-piece part. In case of the application of connecting a radio board to a filter unit, for example, the RF connector comprises: a board connector, which can be soldered on the side of a printed circuit board (PCB) of a radio unit; a cavity connector, which can be pressed into or screwed into a cavity of the filter unit; and a bullet installed between the board connector and the cavity connector. In case of the application of connecting a radio board to an antenna board, the bullet is installed between a first board connector on a first PCB of a radio unit and a second board connector on a second PCB of an antenna unit.

The bullet of each kind of 3-piece RF connectors has the same structure which includes an outer conductor portion, a center conductor portion and an insulator between the outer conductor portion and the center conductor portion. By means of the transmission loop formed by the outer conductor portion and the center conductor portion as well as the PCB /cavity and the connectors thereon, current transmission goes through the center conductor portion and comes back via the outer conductor portion. The mechanical and electrical performance of the RF connector, such as offset tolerance and RF reflection, will depend on the specific design of different variants of the RF connector.

Since the existing 3-piece design of the RF connector consists of a center conductor, an insulator and an outer conductor, many parts are required for producing a RF connector, resulting in complex production and high production cost.

Especially, during inserting the bullet to the board connector or cavity connector, both the center conductor portion and the outer conductor portion are under press and to be mated with counter parts at the same time. This will increase the damage risk for the board connector or cavity connector or the bullet.

Traditional 3-piece RF connector solution could have a couple of potential quality issues such as poor soldering on the board connector and stochastic damage on either the board connector / cavity connector or the bullet during assembly. It is hard to find the quality defects until system level test is performed during volume production. US 2020/203901 shows an electrical plug-in connection, assembly connection and circuit board arrangement. US 2018/301834 shows a plug-and-socket connector. US 2020/091665 shows a coaxial connector assembly.

### Summary

This summary is provided to introduce a selection of concepts in a simplified form that are further described below in the detailed description. This summary is not intended to identify key features or essential features of the claimed subject matter, nor is it intended to be used to limit the scope of the claimed subject matter.

The object of the invention is to provide an improved solution for the RF connector which has a simplified structure and thus can simplify the production and reduce the production cost and also the assembly cost, and which provides improved quality and lengthened lifespan of the RF connector.

The invention is defined by the features of independent claim 1.

With the RF connector of the invention, the elastic connection assembly and the central body function together as an inner conductor. A special outer electrical connection can be formed by an outer conductor with outer electral contacts. Therefore, the RF connector of the present disclosure has a structure much simpler as compared with the traditional 3-piece RF connector. In one particular embodiment, the housing of the outer conductor is in the form of a metal sleeve or a metal barrel.

In an embodiment of the disclosure, the inner conductor has male joints on both ends of the central body or female joints on both ends of the central body. This configuration allows producing the RF connector, especially the central body of the inner conductor in an easier way, as the joints on the board side /filter cavity side can be made the same, thus mass production can be carried out with high efficiency.

According to the invention, the female joint has a mating cavity and the male joint has a plurality of elastic strips spaced by a plurality of dividing grooves in the circumferential direction, each of the elastic strips curving outwards in the radial direction such that a circular bulge portion is formed as an abutment portion which is inserted into the mating cavity through its opening and form the abutment connection with an inner wall of the mating cavity. In this case, the female joint can be designed in the shape of a hollow cylinder.

In an embodiment of the disclosure, the opening of the mating cavity has an enlarged guiding portion for guiding the insertion of the male joint into the mating cavity.

In an embodiment of the disclosure, the female joint is provided on the component to be connected, and has a base with a face that is opposite from the opening of the mating cavity and configured for forming planar connection with the component to be connected.

The female joint may have a plurality of elastic strips spaced by a plurality of dividing grooves in the circumferential direction, each of the elastic strips curving inwards in the radial direction such that a neck portion with a reduced circumference is formed as a clamping ring which is configured to abut against an outer circumferential surface of a main body of the male joint.

The male joint may be provided on the component to be connected, and has a support base with a face which is configured for forming planar connection with the component to be connected. In this case, the main body of the male joint can be designed in the shape of a pin.

In an embodiment of the disclosure, the male joint or the female joint that is provided on the component to be connected is in the form of a structural element welded to the component to be connected or is integrally formed with the component to be connected. For example, a recess structure formed in the PCB can be used as the female joint. Also, a hollow cylindrical element welded onto the PCB and protruding from the PCB can be used as the female joint as well.

In an embodiment of the disclosure, the central body and the male joint(s) or the female joint(s) provided on the ends of the central body are formed as an integral piece by a sheet metal processing.

In an embodiment of the disclosure, the outer conductor further comprises a conductive gasket and/or conductive glue that is placed in a recess formed at an end of the housing and works as the outer electrical contact.

In an embodiment of the disclosure, the conductive gasket comprises a ring-like metal spring with a plurality of elastic electrical contacts which are equally spaced in the circumferential direction and are configured to allow elastic deformation in the axial direction of the outer conductor.

In an embodiment of the disclosure, the conductive glue is placed around the periphery of the metal spring.

The component to be connected may be a PCB, and the housing of the outer conductor may be integrally formed with an EMC cover provided on the PCB.

In an embodiment of the disclosure, the RF connector further comprises a dielectric insulator placed in the annular space between the inner conductor and the outer conductor, and the central body of the inner conductor is directly connected to the component to be connected by means of the elastic connection assembly, without involving the dielectric insulator.

In an embodiment of the disclosure, no dielectric insulator is provided in the annular space between the inner conductor and the outer conductor.

According to a second aspect of the present disclosure, a communication module is provided, which comprises a first component to be connected, a second component to be connected, and the above-said RF connector(s) provided between the first and second components and connecting the two to form a signal transmission loop. The first component to be connected may be a PCB, and the second component to be connected may be another PCB or a cavity filter.

With the RF connector of the present disclsoure, the joint(s) of the elastic connection assembly that is provided on the PCB or the cavity filter and the central body of the inner conductor are connected directly without involving the outer conductor and/or, optionally, without involving the dielectric insulator provided beween the the inner conductor and the outer conductor, and an outer electrical connection is realized separately in an axial direction with a connection chain consisting of a circle ring of contact pad of the PCB, a metal sleeve and the highly conductive gasket/glue or copper spring between the contact pad and the metal sleeve.

So, in a particular embodiment of the RF connector of the present disclosure, only the inner conductor and the outer conductor are indispensable components, and the insulator could be omitted in many conditions. Hence, the RF connector of the present disclosure has a very simple structure as a whole.

A plurality of metal sleeves serving as the housing of the outer conductor could be integrated into a single metal part using a die casting technology, which thus provides improved production efficiency and allows more complexity in design.

Also, the central body of the inner conductor of the present disclosure is simple and can be manufactured by a sheet metal processing, including but not limited to deep drawing, stamping and bending. The overall cost of the RF connector is lower than the existing 3-piece solution for each connection loop. It will be an attractive benefit for 5G Massive multiple input multiple output (MIMO) radio product from cost saving point of view.

Furthemore, as compared with existing 3-piece design of the RF connector, the RF connecor of the present disclosure has only a male/female joint of an elastic connection assembly of the inner conductor functioning as the board connector/the cavity connector of the existing RF connector, without the need of paying attention to co-planarity issues appearing in the board connector/the cavity connector of the existing RF connector. During soldering the male/female joint to the PCB, there is very low risk of poor soldering. Furthermore, during the assembly process, simple mating of the male and female joints of the elastic connection assembly will result in a very low assembly failure rate. The soldering and assembly quality will be improved therefore in mass production as a result of the simplified structure design of the RF connector according to the present disclosure.

### Brief Description of the Drawings

These and other objects, features and advantages of the disclosure will become apparent from the following detailed description of illustrative embodiments thereof, which are to be read in connection with the accompanying drawings.
FIG. 1A shows a sectional view of an RF connector according to a first embodiment of the present disclosure mounted between a first PCB and a second PCB;
FIG. 1B shows a perspective view of a board connector in the form of a male joint of an elastic connection assembly of the RF connector according to the first embodiment;
FIG. 1C shows a perspective view of a main part of an inner conductor of the RF connector of the first embodiment, which is provided with female joints at its ends;
FIG. 1D shows a perspective view of a conductive gasket for the RF connector of the first embodiment;
FIG. 1E shows a perspective view of a copper spring for the RF connector of the first embodiment;
FIG. 2A shows a sectional view of an RF connector according to a second embodiment of the present disclosure mounted between a first PCB and a second PCB;
FIG. 2B shows a perspective view of a board connector in the form of a female joint of an elastic connection assembly of the RF connector according to the second embodiment;
FIG. 2C shows a perspective view of a main part of an inner conductor of the RF connector of the second embodiment, which is provided with male joints at its ends;
FIG. 3 shows a sectional view of an RF connector according to a third embodiment of the present disclosure, which has a dielectric insulator provided between an outer conductor and an inner conductor;
FIG. 4 shows a sectional view of an RF connector according to a fourth embodiment of the present disclosure, which is applied for the connection between a first PCB and a second PCB with through-holes provided thereon as female joints;
FIG. 5 shows a sectional view of an RF connector according to a fifth embodiment of the present disclosure, which is applied for the connection between a PCB and a cavity filter having a recess provided thereon as a female joint.
FIG. 6 shows a sectional view of an RF connector according to a sixth embodiment of the present disclosure, which is applied for the connection between a PCB and a cavity filter having a cavity with a protrusion integrally protruding from the bottom of the cavity as a male joint.
FIG. 7 shows a sectional view of an RF connector according to a seventh embodiment of the present disclosure for a board-to-board connection, in which a metal sleeve integrally formed on an EMC cover is used as a metal sleeve of an outer conductor; and
FIG. 8 shows a sectional view of an RF connector according to an eighth embodiment of the present disclosure for a board-to-board connection, in which conductive gaskets are placed around copper springs for stable current transmission between the outer conductor and the PCBs.

### Detailed Description

The invention corresponds to the second embodiment. All other embodiments are not part of the invention.

Generally, applications of an RF connector can be classified into following two types: a board-to-board application, in which the RF connector is mounted between two PCBs; and a board-to-cavity application, in which the RF connector is mounted between a PCB and a cavity filter. For clearly illustrating the RF connector of the present disclosure, the board-to-board application and the board-to-cavity application are explained separately as follows:

### Board-to-Board Application

### First Embodiment

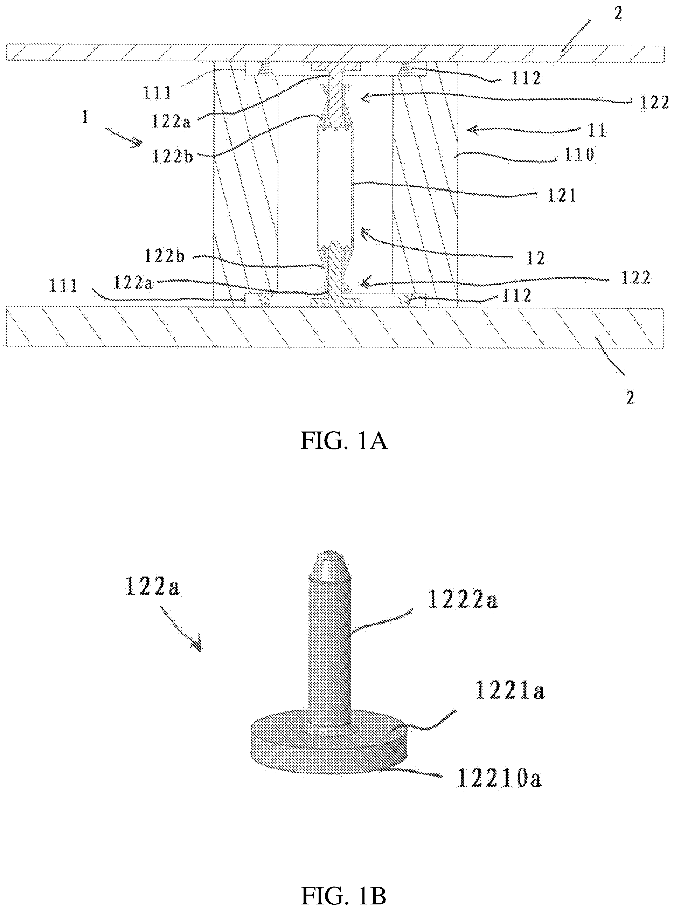

FIG. 1A shows an RF connector 1 according to a first embodiment of the present disclosure. The RF connector 1 comprises an outer conductor 11 which is electrically connected with the first and second PCBs 2 by electrical contacts at its ends, and an inner conductor 12 comprising a central body 121 and elastic connection assemblies 122 provided in each end region of the central body 121 for electrically connecting the central body 121 to the PCBs 2. The outer conductor 11 has a hollow housing which is embodied as a metal sleeve 110. At each end of the metal sleeve 110, a recess 111 is formed and communicates with a central bore of the metal sleeve 110, thereby forming a stepped hole. A ring of conductive material 112 is placed in each recess 111, working as outer electrical contacts abutting against contact pads of each PCB board 2. The inner conductor 12 is installed in a central bore of the metal sleeve 110 and spaced from an inner wall of the metal sleeve 110, thereby an annular space is formed therebetween. Each elastic connection assembly 122 comprises a male joint 122a and a female joint 122b which mate to each other to form an abutment connection. At least one of the male joint 122a and the female joint 122b has elasticity in a radial direction in the area of the abutment connection.

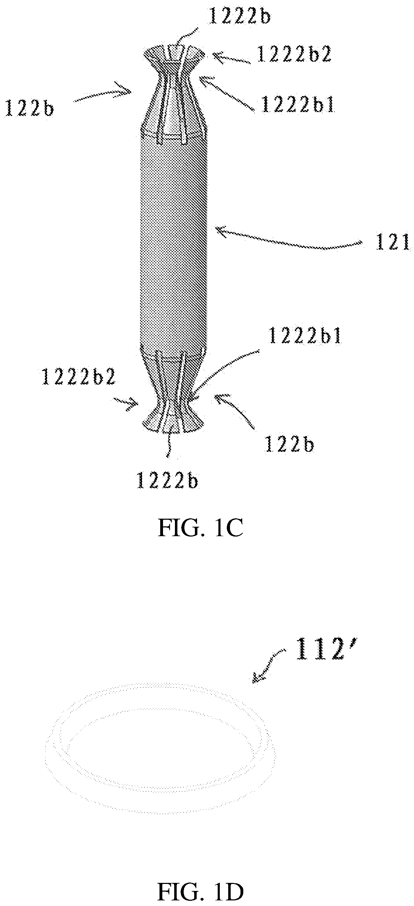

Referring to FIG. 1B, it can be seen that the male joint 122a, which works as a board connector, is embodied as a rivet-like component, comprising a support base 1221a with a planar face 12210a configured for forming planar connection with the PCB board 2, and a pin-shaped element 1222a protruding from the support base 1221a as a main body of the male joint 122a. The support base 1221a can be soldered to the PCB board 2 directly with the planar face 12210a abutting against the PCB board 2. Referring to FIG. 1C, the female joint 122b provided on each end of the central body 121 is embodied as a grasping part, which comprises a plurality of elastic strips 1222b spaced by a plurality of dividing grooves in the circumferential direction, each of the elastic strips 1222b curving inwards in the radial direction such that a neck portion 1222b1 with a reduced circumference is formed as a clamping ring which is configured to abut against an outer circumferential surface of the pin-shaped element 1222a of the male joint 122a. With the provision of the elastic strips 1222b, elastic force provided thereby may help to adapt to the pin-shaped element 1222a with different diameters and also enables easy insertion of the pin-shaped element 1222a into the female joint 122b or easy extraction of the pin-shaped element 1222a from the female joint 122b.

Preferably, the female joint 122b has a horn-like guiding skirt 1222b2 provided in the end area of the elastic strips 1222b and extending outwards from the neck portion 1222b1. This horn-like guiding skirt 1222b2 may help to guide the insertion of the pin-shaped element 1222a of the male joint 122a into the neck portion 1222b1 of the female joint 122b.

As can be seen from FIG. 1C, the female joints 122b are integrally formed with the central body 121 into an integral piece. This integral piece can be formed by a sheet metal processing, such as deep drawing, cutting, bending, punching or welding. Therefore, the overall cost of the RF connector can be greatly reduced.

As can be seen from FIGs. 1A, 1B and 1C, the inner conductor 12 is actually a 3-piece part as a whole, providing the central electrical connection between the first and second PCBs 2. And this central electrical connection can be achieved independently, without involving any operations regarding the outer conductor 11. That is to say, no matter whether the outer conductor is arranged in place or not, the inner conductor 12 can be assembled well and put into a position ready for realizing the central electrical connection between the two PCBs 2.

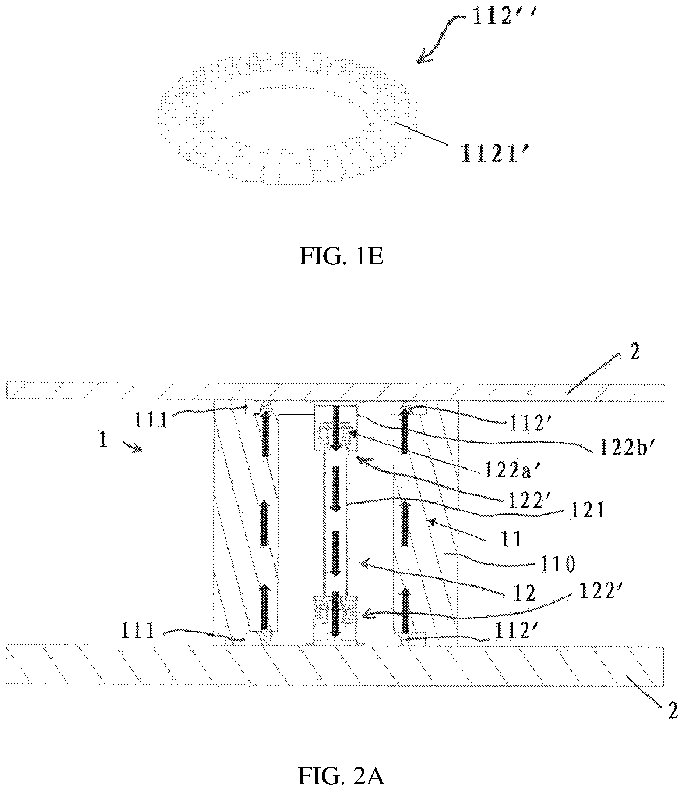

As indicated with respect to FIG. 1A, a ring of conductive material 112 is placed in the recess 111 at each end of the metal sleeve 110. The conductive material 112 can be embodied as a conductive gasket 112' (which is shown clearly in FIG. 1D), conductive glue, or a ring-like metal spring 112" (for example, a copper spring as shown in FIG. 1E). The metal spring 112" may comprise a plurality of elastic electrical contacts 1121" which are equally spaced in the circumferential direction and are configured to allow elastic deformation in the axial direction of the metal sleeve 110. Once the conductive materials 112 in the recesses 111 are compressed and thus abut against predetermined portions of the PCBs, an outer electrical connection is formed thereby. It can be easily understood that, the conductive gasket, the conductive glue and the metal spring can be used either alone or in combination.

During the working of the RF connector 1 according to the first embodiment, the current will transmit through the inner conductor 12, and then goes back via conductive materials 112 and the metal sleeve 11 (as shown by the arrows in FIG. 2A), forming a signal transmission loop.

### Second Embodiment

FIG. 2A shows a second embodiment of an RF connector 1 of the present disclosure. As compared with the first embodiment, the second embodiment of the RF connector differs only in the configuration of the elastic connection assembly 122'.

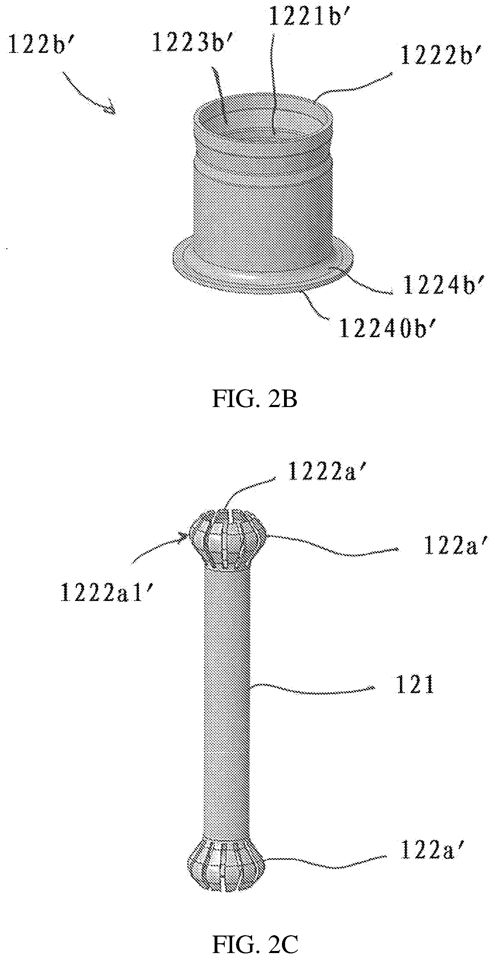

Specifically, in the second embodiment of the RF connector 1, the male joint 122a' of the elastic connection assembly 122' is provided at the end of the central body 121, and the female joint 122b' is provided on the PCB board 2 as a board connector in the form of a barrel-shaped component having a mating cavity 1221b' (as shown in FIG. 2B). The mating cavity 1221b' has an opening 1222b' for the insertion of the male joint 122a'. The male joint 122a', as shown in FIG. 2C, comprises a plurality of elastic strips 1222a' spaced by a plurality of dividing grooves in the circumferential direction. Each of the elastic strips 1222a' curves outwards in the radial direction such that a circular bulge portion 1222a1' is formed as an abutment portion which is inserted into the mating cavity 1221b' of the female joint 122b' via the opening 1222b' and forms an abutment connection with an inner wall of the mating cavity 1221b'. Preferably, near the opening 1222b' of the mating cavity 1221b', there is an enlarged guiding portion 1223b' formed by an end portion of the wall of the mating cavity for guiding the insertion of the male joint 122a' into the interior of the mating cavity 1221b'. The female joint 122b' has a base 1224b' with a planar face 12240b' that is opposite from the opening 1222b' and configured for forming planar connection with the PCB 2. With this planar face 12240b', the female joint 122b' can be soldered to the PCB 2 directly.

As can be seen from FIG. 2C, the male joints 122a' are integrally formed with the central body 121 into an integral piece. This integral piece can be formed by a sheet metal processing, such as deep drawing, cutting, bending, punching or welding. Therefore, the overall cost of the RF connector can be greatly reduced.

As can be seen from FIGs. 2A, 2B and 2C, the inner conductor 12 is configured as a 3-piece part as a whole. The inner conductor 12 can be electrically connected with the PCBs 2 via the mating of the male joints 122a' and female joints 122b' soldered on the PCBs 2. The inner conductor 12 can be well assembled independently, without involving any operations regarding the outer conductor 11.

### Third Embodiment

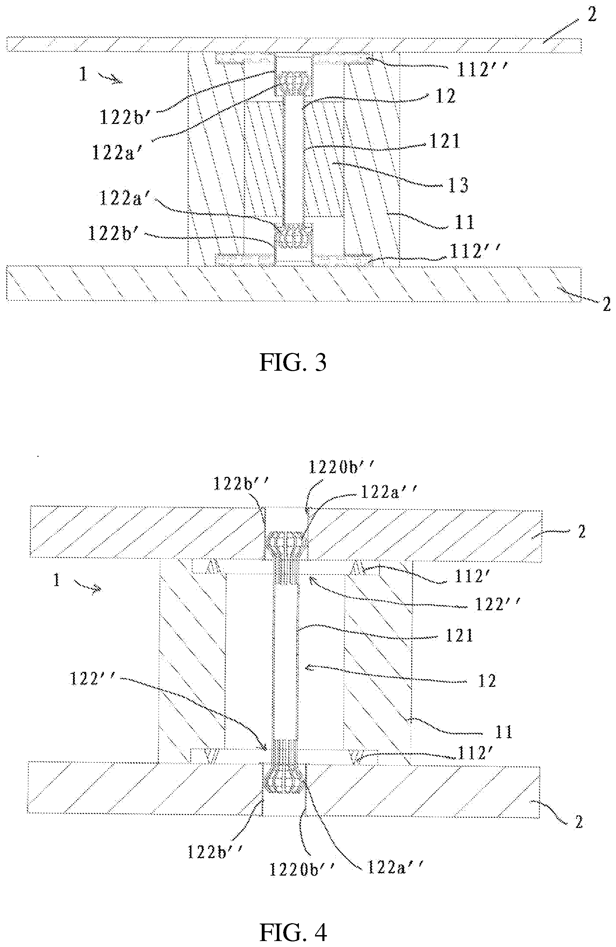

FIG. 3 shows a third embodiment of an RF connector 1 of the present disclosure. As compared with the second embodiment, the third embodiment of the RF connector 1 uses a metal spring 112" (rather than a conductive gasket 112') as the conductive material 112 and also adds a dielectric insulator 13 in the annular space between the inner conductor 12 and the outer conductor 11.

Generally speaking, the dielectric insulator 13 is not mandatorily needed. But in cases that impedance matching optimization or installation robustness calls for special attention, the dielectric insulator 13 could be flexibly designed with various forms and shapes and mounted around the central body 121 of the inner conductor 12 accordingly.

### Fourth Embodiment

FIG. 4 shows a fourth embodiment of an RF connector 1 of the present disclosure. As compared with the second embodiment, the fourth embodiment of the RF connector differs in the configuration of the female joint 122b".

Specifically, through-holes are formed in each PCB 2 and function as the mating cavities of the female joints 122b". For reliable connection between the female joint 122a" and the male joint 122b", a metal coating or a metal layer 1220b" may be applied to inner wall of the through-holes.

Although it is shown in FIG.4 that through-holes formed on the PCBs 2 can function as the mating cavities of the female joint, it is easily conceivable that other forms of hollow structure, for example, blind holes, grooves or notches, can be provided in the PCBs as well to provide female joints for mating with the male joints 122a".

### Board-to-Cavity Application

RF connectors are also widely applied in the connection scenario between a PCB and a cavity filter in a radio base station product.

Similar to the board-to-board application, the board-to-cavity application also uses an inner conductor to provide a central electrical connection between the PCB and the metal cavity part of the cavity filter, and uses an outer conductor (consisting of a compressed conductive material and a metal sleeve) to provide an outer electrical connection between the PCB and the metal cavity part of the cavity filter.

### Fifth Embodiment

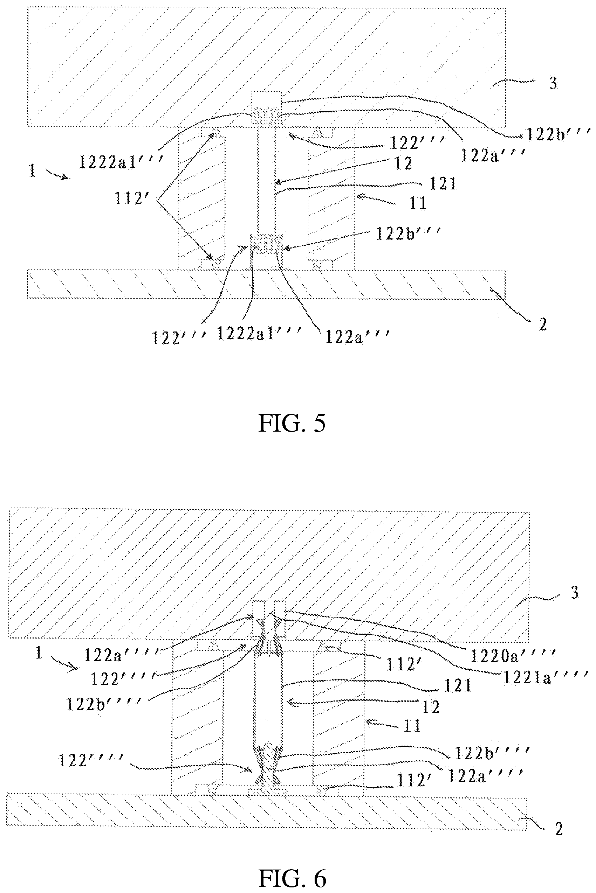

FIG. 5 shows a fifth embodiment of an RF connector 1 of the present disclosure. A cavity filter 3 has at least a cavity 122b‴ inherently formed on its metal part. The cavity 122b‴ can be used directly as a female joint of the elastic connection assembly 122‴ for the RF connector 1, without the need of separately providing an addition element as a female joint. In this case, a male joint 122a‴ is designed correspondingly to have a circular bulge portion 1222a1‴ which can be inserted into the cavity 122b‴ through its opening and forms an abutment connection with an inner wall of the cavity 122b"'.

### Sixth Embodiment

FIG. 6 shows a sixth embodiment of an RF connector 1 of the present disclosure. On a side of the metal cavity part of the cavity filter 3 facing the PCB 2, there is a cavity 1220aʺʺ formed with a protrusion 1221aʺʺ extending from the bottom of the cavity 1220a"". For matching with this particular male joint 122aʺʺ comprising the cavity 1220aʺʺ and the protrusion 1221a"", a female joint 122bʺʺ is designed in the form of a grasping part. Once the female joint 122bʺʺ is inserted into the cavity 1220aʺʺ, the protrusion 1221aʺʺ slides into the grasping part in the meantime. As a result, the clamping ring of the grasping part abuts against the outer circumferential surface of the protrusion 1221aʺʺ under the action of the elastic force of the elastic connection assembly 122ʺʺ. In this case, the protrusion 1221aʺʺ can be used directly as a pin-shaped main body of the male joint, without the need of separately providing an additional element as the male joint.

### Seventh Embodiment

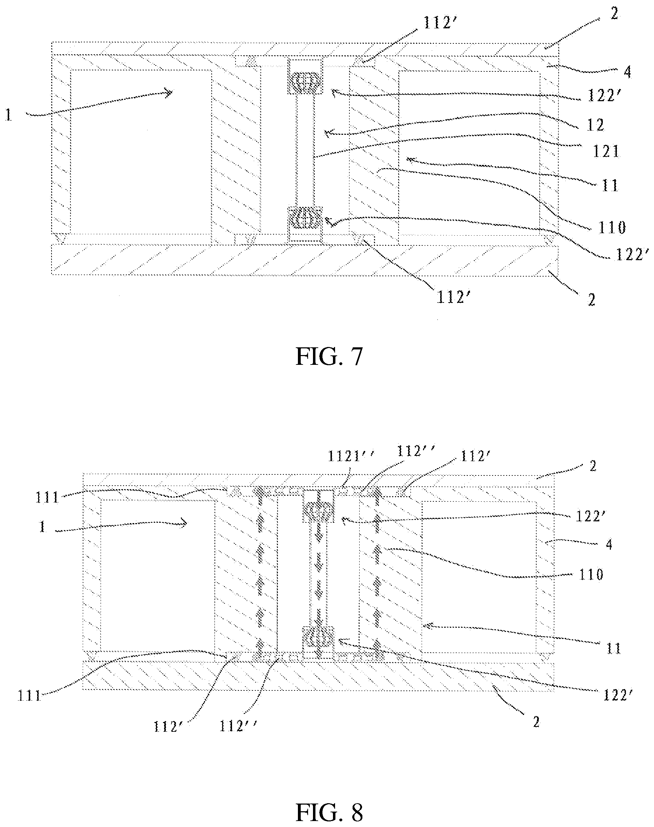

FIG. 7 shows a seventh embodiment of an RF connector 1 of the present disclosure. As compared with the second embodiment, the seventh embodiment of the RF connector differs in the configuration of the metal sleeve 110 of the outer conductor 11.

In the radio station, there will always be metal part designed surrounding the radio transmitting channel due to the EMI shielding consideration. Taking the advantage of an EMC cover 4, the seventh embodiment develops a special outer electrical connection instead of using a separate outer conductor itself. In the seventh embodiment, the metal sleeve 110 is formed integrally on the EMC cover 4. Hence, it is possible to integrate a plurality of metal sleeves into a single EMC cover using a die casting technology, therefore improving production efficiency and reducing production cost.

### Eighth Embodiment

Fig. 8 shows an eighth embodiment of an RF connector 1 of the present disclosure. As compared with the seventh embodiment, the eighth embodiment of the RF connector differs in the arrangement of conductive materials 112 in a recess 111 formed at the end of the metal sleeve 110.

Specifically, a conductive gasket 112' is placed in the recess 111 and extends around the periphery of a metal spring 112", for the purpose of shielding. Meanwhile, the metal spring 112", for example, a copper spring, is placed in such a manner that the elastic contacts 1121" thereof can abut against the contact pad on the PCB 2 and realize the electrical connection therebetween.

### Other Embodiments

Although it is shown in all the above embodiments of RF connector 1 that the joints provided at both ends of the central body 121 are of the same configuration, it is easily conceivable that they can be designed in different configurations. For example, one joint at a first end of the central body 121 is in the form of a grasping part (as shown in FIG. 1C) for grasping a pin-shaped portion of a male joint on the PCB or cavity filter, and the other joint at the second end of the central body 121 is formed with a bulging portion (as shown in FIG. 2C) for forming an abutment connection with a female joint on the PCB or cavity filter. Matching joints for each joint at the end of the central body 121 can be provided accordingly in view of the specific configuration of the PCB or the cavity filter to be connected.

Also, no matter whether a dielectric insulator is provided in the annular space between the metal sleeve 110 of the outer conductor 11 and the central body 121 of the inner conductor 12 or not, the central body 121 of the inner conductor 12 can be directly connected to the PCB(s) or the cavity filter by means of the elastic connection assembly, without involving the outer conductor or the dielectric insulator. In other words, when assembling the RF connector 1 of the present disclosure, it is not necessary that both the central body of the inner conductor and metal sleeve of the outer conductor should be handled at the same time. For example, the operator can put the central body of the inner conductor in a right place for the matching of the female and male j oints, without taking the handling of the metal sleeve or the dielectric insulator (if any) into consideration. Thus, there is no need to consider concentricity issue occurring with the inner conductor and the outer conductor, and the soldering defects caused by low co-planarity in the board connectors of the existing RF connectors can be eliminated. Therefore, the RF connector of the present disclosure allows easy and flexible assembling and improved durability or lengthened life span.

## Claims

1. A radio frequency connector (1), comprising:
an outer conductor (11) having a hollow housing with outer electrical contacts at its ends; and
an inner conductor (12) comprising a central body (121) configured to be installed inside the outer conductor (11) and spaced from the outer conductor with an annular space therebetween;
wherein in each end region of the central body (121) of the inner conductor (12), an elastic connection assembly (122') is provided for electrically connecting the central body (121) to a component (2) to be connected,
the elastic connection assembly (122') comprises a male joint (122a') and a female joint (122b') which mate with each other to form an abutment connection, , the male joint (122a') being provided on the central body (121), and the female joint (122b') arranged for being provided on a component to be connected (2), and
the central body (121) of the inner conductor (12) is directly connectable to the component (2) to be connected by means of the elastic connection assembly (122'), without involving the outer conductor (11), **characterized in that** the male joint (122a') has elasticity in a radial direction in the area of the abutment connection, and wherein the female joint (122b') has a mating cavity (1221b') and the male joint (122a') has a plurality of elastic strips (1222a') spaced by a plurality of dividing grooves in the circumferential direction, each of the elastic strips (1222a') curving outwards in the radial direction such that a circular bulge portion is formed as an abutment portion which is to be inserted into the mating cavity (1221b') through its opening and form the abutment connection with an inner wall of the mating cavity (1221b').

2. The radio frequency connector (1) according to claim 1, wherein the inner conductor (12) has male joints (122a') on both ends of the central body (121)

3. The radio frequency connector (1) according to claim 1 or 2, wherein the opening (1222b') of the mating cavity (1221b') has an enlarged guiding portion (1223b') for guiding the insertion of the male joint (122a') into the mating cavity (1221b').

4. The radio frequency connector (1) according to any of claims 1-3, wherein the female joint (122b') is to be provided on the component (2) to be connected, and has a base (1224b') with a face (12240b') that is opposite from the opening (1222b') of the mating cavity (1221b') and configured for forming planar connection with the component (2) to be connected.

5. The radio frequency connector (1) according to any one of claims 1-4, wherein the female joint (122b') that is to be provided on the component (2) to be connected is in the form of a structural element to be welded to the component (2) to be connected or is to be integrally formed with the component (2) to be connected.

6. The radio frequency connector (1) according to any one of claims 1-5, wherein the central body (121) and the male joint (122a') provided on the end of the central body (121) are formed as an integral piece by a sheet metal processing.

7. The radio frequency connector (1) according to any one of claims 1-6, wherein the outer conductor (11) further comprises a conductive gasket (112') and/or conductive glue that is placed in a recess (111) formed at an end of the housing and works as the outer electrical contact.

8. The radio frequency connector (1) according to claim 7, wherein the conductive gasket (112') comprises a ring-like metal spring (112'') with a plurality of elastic electrical contacts (1121'') which are equally spaced in the circumferential direction and are configured to allow elastic deformation in the axial direction of the outer conductor (11).

9. The radio frequency connector according to claim 8, wherein the conductive glue is placed around the periphery of the metal spring (112").

10. The radio frequency connector (1) according to any one of claims 1-9, further comprising a dielectric insulator (13) placed in the annular space between the inner conductor (12) and the outer conductor (11), and the central body (121) of the inner conductor (12) is to be directly connected to the component (2) to be connected by means of the elastic connection assembly without involving the dielectric insulator (13).

11. A communication module, comprising a first component (2) to be connected, a second component (2) to be connected, **characterized in that** the communication module further comprises a radio-frequency connector (1) according to any one of claims 1-10, which is provided between the first and second components and connects the two to form a signal transmission loop, wherein the first component (2) to be connected is a printed circuit board, and the second component (2) to be connected is another printed circuit board or a cavity filter.

## Patentansprüche

1. Hochfrequenzverbinder (1), umfassend:
einen Außenleiter (11) mit einem hohlen Gehäuse und äußeren elektrischen Kontakten an seinen Enden; und
einen Innenleiter (12), der einen zentralen Körper (121) umfasst, der dazu ausgelegt ist, innerhalb des Außenleiters (11) installiert und von dem Außenleiter mit einem ringförmigen Raum dazwischen beabstandet zu sein;
wobei in jeder Endregion des zentralen Körpers (121) des Innenleiters (12) eine elastische Verbindungsanordnung (122') zum elektrischen Verbinden des zentralen Körpers (121) mit einer anzuschließenden Komponente (2) vorgesehen ist,
die elastische Verbindungsanordnung (122')) einen Steckanschluss (122a') und einen Aufnahmeanschluss (122b') umfasst, die miteinander verbunden sind, um eine Anschlagverbindung zu bilden, wobei der Steckanschluss (122a') an dem zentralen Körper (121) vorgesehen ist und der Aufnahmeanschluss (122b') dazu eingerichtet ist, auf einer anzuschließenden Komponente (2) vorgesehen zu sein, und
der zentrale Körper (121) des Innenleiters (12) anhand der elastischen Verbindungsanordnung (122') direkt mit der anzuschließenden Komponente (2) verbunden werden kann, ohne den Außenleiter (11) einzubeziehen,
**dadurch gekennzeichnet, dass**
der Steckanschluss (122a') in dem Bereich der Anschlagverbindung in einer radialen Richtung Elastizität aufweist und wobei der Aufnahmeanschluss (122b') einen passenden Hohlraum (1221b') aufweist und der Steckanschluss (122a') eine Mehrzahl von elastischen Streifen (1222a') aufweist, die durch eine Mehrzahl von teilenden Nuten in der Umfangsrichtung beabstandet ist, wobei sich jeder der elastischen Streifen (1222a') in der radialen Richtung so nach außen krümmt, dass ein kreisförmiger Wölbungsabschnitt als ein Anschlagabschnitt ausgebildet ist, der in den passenden Hohlraum (1221b') durch seine Öffnung einzuführen ist und die Anschlagverbindung mit einer Innenwand des passenden Hohlraums (1221b') bildet.

2. Hochfrequenzverbinder (1) nach Anspruch 1, wobei der Innenleiter (12) Steckanschlüsse (122a') an beiden Enden des zentralen Körpers (121) aufweist.

3. Hochfrequenzverbinder (1) nach Anspruch 1 oder 2, wobei die Öffnung (1222b') des passenden Hohlraums (1221b') einen vergrößerten Führungsabschnitt (1223b') zum Führen der Einführung des Steckanschlusses (122a') in den passenden Hohlraum (1221b') aufweist.

4. Hochfrequenzverbinder (1) nach einem der Ansprüche 1-3, wobei der Aufnahmeanschluss (122b') auf der anzuschließenden Komponente (2) vorzusehen ist und eine Basis (1224b') mit einer Fläche (12240b') aufweist, die der Öffnung (1222b') des passenden Hohlraums (1221b') gegenüberliegt und dazu ausgelegt ist, eine planare Verbindung mit der anzuschließenden Komponente (2) zu bilden.

5. Hochfrequenzverbinder (1) nach einem der Ansprüche 1-4, wobei der auf der anzuschließenden Komponente (2) vorzusehende Aufnahmeanschluss (122b') die Form eines an die anzuschließende Komponente (2) zu schweißendes Strukturelements aufweist oder einstückig mit der anzuschließenden Komponente (2) auszubilden ist.

6. Hochfrequenzverbinder (1) nach einem der Ansprüche 1-5, wobei der zentrale Körper (121) und der an dem Ende des zentralen Körpers (121) vorgesehene Steckanschluss 122a') durch Blechbearbeitung als einstückiges Teil ausgebildet sind.

7. Hochfrequenzverbinder (1) nach einem der Ansprüche 1-6, wobei der Außenleiter (11) ferner eine leitfähige Dichtung (112') und/oder einen leitfähigen Klebstoff aufweist, die/der in einer Aussparung (111) platziert ist, die an einem Ende des Gehäuses ausgebildet ist und als der äußere elektrische Kontakt dient.

8. Hochfrequenzverbinder (1) nach Anspruch 7, wobei die leitfähige Dichtung (112') eine ringartige Metallfeder (112'') mit einer Mehrzahl von elastischen elektrischen Kontakten (1121'') umfasst, die in der Umfangsrichtung gleichmäßig beabstandet und dazu ausgelegt ist, elastische Verformung in der axialen Richtung des Außenleiters (11) zu ermöglichen.

9. Hochfrequenzverbinder nach Anspruch 8, wobei der leitfähige Klebstoff um den Umfang der Metallfeder (112'') platziert ist.

10. Hochfrequenzverbinder (1) nach einem der Ansprüche 1-9, ferner umfassend einen dielektrischen Isolator (13), der in dem ringförmigen Raum zwischen dem Innenleiter (12) und dem Außenleiter (11) platziert ist und der zentrale Körper (121) des Innenleiters (12) anhand der elastischen Verbindungsanordnung direkt mit der anzuschließenden Komponente (2) zu verbinden ist, ohne den dielektrischen Isolator (13) einzubeziehen.

11. Kommunikationsmodul, umfassend eine erste anzuschließende Komponente (2) und eine zweite anzuschließende Komponente (2), **dadurch gekennzeichnet, dass** das Kommunikationsmodul ferner einen Hochfrequenzverbinder (1) nach einem der Ansprüche 1-10 umfasst, der zwischen der ersten und der zweiten Komponente vorgesehen ist und die beiden verbindet, um eine Signalübertragungsschleife zu bilden, wobei die erste anzuschließende Komponente (2) eine Leiterplatte ist und die zweite anzuschließende Komponente (2) eine andere Leiterplatte oder ein Hohlraumfilter ist.

## Revendications

1. Connecteur radiofréquence (1), comprenant :
un conducteur extérieur (11) présentant un boîtier creux avec des contacts électriques extérieurs à ses extrémités ; et
un conducteur intérieur (12) comprenant un corps central (121) configuré pour être installé dans le conducteur extérieur (11) et espacé du conducteur extérieur d'un espace annulaire entre eux ;
dans lequel, dans chaque région d'extrémité du corps central (121) du conducteur intérieur (12), un assemblage de connexion élastique (122') est prévu pour connecter électriquement le corps central (121) à un composant (2) à connecter,
l'assemblage de connexion élastique (122') comprend un raccord mâle (122a') et un raccord femelle (122b') qui s'accouplent l'un à l'autre pour former une connexion par aboutement, le raccord mâle (122a') étant prévu sur le corps central (121), et le raccord femelle (122b') étant agencé pour être prévu sur un composant à connecter (2), et
le corps central (121) sur le conducteur intérieur (12) peut être directement connecté au composant (2) à connecter au moyen de l'assemblage de connexion élastique (122'), sans impliquer le conducteur extérieur (11),
**caractérisé en ce que** le raccord mâle (122a') présente une élasticité dans une direction radiale dans la zone de la connexion par aboutement, et dans lequel le raccord femelle (122b') présente une cavité d'accouplement (1221b') et le raccord mâle (122a') présente une pluralité de bandes élastiques (1222a') espacées par une pluralité de rainures de division dans la direction circonférentielle, chacune des bandes élastiques (1222a') s'incurvant vers l'extérieur dans la direction radiale de sorte qu'une partie bombée circulaire soit formée comme partie d'aboutement qui doit être insérée dans la cavité d'accouplement (1221b') à travers son ouverture et former la connexion par aboutement avec une paroi intérieure de la cavité d'accouplement (1221b').

2. Connecteur radiofréquence (1) selon la revendication 1, dans lequel le conducteur intérieur (12) présente des raccords mâles (122a') aux deux extrémités du corps central (121).

3. Connecteur radiofréquence (1) selon la revendication 1 ou 2, dans lequel l'ouverture (1222b') de la cavité d'accouplement (1221b') présente une partie de guidage élargie (1223b') pour guider l'insertion du raccord mâle (122a') dans la cavité d'accouplement (1221b').

4. Connecteur radiofréquence (1) selon l'une quelconque des revendications 1 à 3, dans lequel le raccord femelle (122b') doit être prévu sur le composant (2) à connecter, et présente une base (1224b') avec une face (1224b') qui est opposée à l'ouverture (1222b') de la cavité d'accouplement (1221b') et configurée pour former une connexion plane avec le composant (2) à connecter.

5. Connecteur radiofréquence (1) selon l'une quelconque des revendications 1 à 4, dans lequel le raccord femelle (122b') qui doit être prévu sur le composant (2) à connecter se présente sous la forme d'un élément structurel à souder au composant (2) à connecter ou est formé d'un seul tenant avec le composant (2) à connecter.

6. Connecteur radiofréquence (1) selon l'une quelconque des revendications 1 à 5, dans lequel le corps central (121) et le raccord mâle (122a') prévu à l'extrémité du corps central (121) sont formés d'un seul tenant par tôlerie.

7. Connecteur radiofréquence (1) selon l'une quelconque des revendications 1 à 6, dans lequel le conducteur extérieur (11) comprend en outre un joint conducteur (112') et une colle conductrice qui est placée dans un évidement (111) formé à une extrémité du boîtier et sert de contact électrique extérieur.

8. Connecteur radiofréquence (1) selon la revendication 7, dans lequel le joint conducteur (112') comprend un ressort métallique annulaire (112'') avec une pluralité de contacts électriques élastiques (1121'') qui sont équidistants dans la direction circonférentielle et sont configurés pour permettre une déformation élastique dans la direction axiale du conducteur extérieur (11).

9. Connecteur radiofréquence selon la revendication 8, dans lequel la colle conductrice est placée autour de la périphérie du ressort métallique (112'').

10. Connecteur radiofréquence (1) selon l'une quelconque des revendications 1 à 9, comprenant en outre un isolant diélectrique (13) placé dans l'espace annulaire entre le conducteur intérieur (12) et le conducteur extérieur (11), et le corps central (121) du conducteur intérieur (12) doit être connecté directement au composant (2) à connecter au moyen de l'assemblage de connexion élastique sans impliquer l'isolant diélectrique (13).

11. Module de communication, comprenant un premier composant (2) à connecter, un deuxième composant (2) à connecter, **caractérisé en ce que** le module de communication comprend en outre un connecteur radiofréquence (1) selon l'une quelconque des revendications 1 à 10, qui est prévu entre les premier et deuxième composants et les connecte l'un à l'autre pour former une boucle de transmission de signal, dans lequel le premier composant (2) à connecter est une carte de circuit imprimé, et le deuxième composant (2) à connecter est une autre carte de circuit imprimé ou un filtre de cavité.
